# EUROPEAN PATENT SPECIFICATION

(11) **EP 3 043 391 B1**
(45) Date of publication and mention of the grant of the patent: **01.05.2019**
(21) Application number: 16150567.2
(22) Date of filing: 08.01.2016
(51) Int. Cl.: H01L 31/05

(54) **PARALLEL INTERCONNECTION OF NEIGHBORING SOLAR CELLS VIA A COMMON BACK PLANE**
PARALLELVERBINDUNG BENACHBARTER SOLARZELLEN ÜBER EINE GEMEINSAME RÜCKWAND
INTERCONNEXION PARALLÈLE DE CELLULES SOLAIRES VOISINES AVEC UN PLAN ARRIÈRE COMMUN

(30) Priority: 08.01.2015 US 201514592519
(43) Date of publication of application: 13.07.2016
(73) Proprietor: SolAero Technologies Corp., Albuquerque, NM 87123 (US)
(72) Inventor: AIKEN, Daniel, Cedar Crest, NM New Mexico 87008 (US); DERKACS, Daniel, Albuquerque, NM New Mexico 13224 (US)
(74) Representative: Balder IP Law, S.L.

(56) References cited:
- US-A- 4 045 245
- US-A1- 2010 089 435
- US-A1- 2010 288 331
- US-A1- 2012 060 895

## Description

### BACKGROUND OF THE DISCLOSURE

### 1. Field of the Disclosure

The disclosure relates to the field of photovoltaic power devices.

### 2. Description of the Related Art

Photovoltaic devices, such as photovoltaic modules or "CIC" (Solar Cell + Interconnects + Coverglass) assemblies, comprise one or more individual solar cells arranged to produce electric power in response to irradiation by solar light. Sometimes, the individual solar cells are rectangular, often square. Photovoltaic modules, arrays and devices including one or more solar cells may also be substantially rectangular, for example, based on an array of individual solar cells. Arrays of substantially circular solar cells are known to involve the drawback of inefficient use of the surface on which the solar cells are mounted, due to space that is not covered by the circular solar cells due to the space that is left between adjacent solar cells due to their circular configuration (cf. U.S. patents nos. 4,235,643 and 4,321,417).

However, solar cells are often produced from circular or substantially circular wafers. For example, solar cells for space applications are typically multi-junction solar cells grown on substantially circular wafers. These circular wafers are sometimes 100 mm or 150 mm diameter wafers. However, as explained above, for assembly into a solar array (henceforth, also referred to as a solar cell assembly), substantially circular solar cells, which can be produced from substantially circular wafers to minimize waste of wafer material and, therefore, minimize solar cell cost, are often not the best option due to their low array fill factor, which increases the overall cost of the photovoltaic array or panel and implies an inefficient use of available space. Therefore the circular wafers are often divided into other form factors to make solar cells.

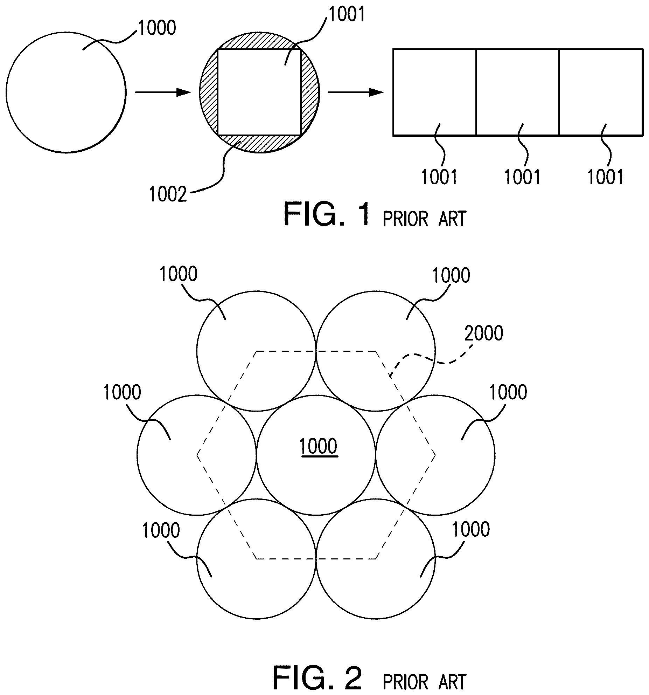

The preferable form factor for a solar cell for space is a rectangle, such as a square, which allows for the area of the rectangular panel consisting of an array of solar cells to be filled 100% (henceforth, that situation is referred to as a "fill factor" of 100%), assuming that there is no space between the adjacent rectangular solar cells. However, when a single circular wafer is divided into a single rectangle, the wafer utilization is low. This results in waste. This is illustrated in Figure 1, showing how conventionally, out of a circular solar cell wafer 1000 a rectangular solar cell 1001 is obtained, leaving the rest of the wafer as waste 1002. This rectangular solar cell 1001 can then be placed side by side with other rectangular solar cells 1001 obtained from other wafers, thereby providing for efficient use of the surface on which the solar cells are placed (i.e., a high fill factor): a large W/m² ratio can be obtained, which depending on the substrate may also imply a high W/kg ratio, of great importance for space applications. That is, closely packed solar cells without any space between the adjacent solar cells is generally preferred, and especially for applications in which W/m² and/or W/kg are important aspects to consider. This includes space applications, such as solar power devices for satellites.

Space applications frequently use high efficiency solar cells, including multi-junction solar cells and/or III/V compound semiconductor solar cells. High efficiency solar cell wafers are often costly to produce. Thus, the waste that has conventionally been accepted in the art as the price to pay for a high fill factor, that is, the waste that is the result of cutting the rectangular solar cell out of the substantially circular solar cell wafer, can imply a considerable cost.

Thus, the option of using substantially circular solar cells, corresponding to substantially circular solar cell wafers, to produce an array or assembly of solar cells, could in some cases become an interesting option. There is a trade-off between maximum use of the original wafer material and the fill factor. Figure 2 shows how circular wafers can be packed according to a layout for maximum use of space, obtaining a fill factor in the order of 90%. This implies that less wafer material is wasted than in the case of the option shown in Figure 1, but also a less efficient use of the surface on which the solar cells are mounted, due to the lower fill factor. A further problem is that with this kind of layout, the pattern features a hexagonal unit cell 2000 (illustrated with broken lines in Figure 2), which is non-optimal for producing a rectangular assembly of solar cells. The hexagonal unit cell is inconvenient for producing rectangular arrays of solar cells because the assembly of solar cells will not fit neatly to the edges or boundaries of a rectangular panel.

It is also known to enhance the wafer utilization and to reduce the waste by obtaining an octagonal -instead of rectangular- solar cell from a substantially circular wafer, namely, a rectangular solar cell with cropped corners. However, whereas this approach makes it possible to reduce the waste of wafer material, it is non-optimal from the point of view of the fill factor, as when the rectangular solar cells with cropped corners are placed in rows and columns to form a solar cell array, the space where the cropped corners meet is left without solar cell material and is thus not used for the conversion of light into electric power.

It is possible to reduce the amount of waste and at the same time achieve a high fill factor by dividing a circular or substantially circular wafer not into two single rectangular, such as square, cell, but into a large number of smaller cells. By dividing a circular or substantially circular wafer into a large amount of relatively small cells, such as rectangular cells, most of the wafer material can be used to produce solar cells, and the waste is reduced. For example, a solar cell wafer having a diameter of 100 mm or 150 mm and a surface area in the order of 80 cm² or 180 cm² can be used to produce a large amount of small solar cells, such as square or rectangular solar cells each having a surface area of less than 5 cm², less than 1 cm², less than 0.1 cm² or even less than 0.05 cm² or less than 0.01 cm². For example, substantially rectangular -such as square- solar cells can be obtained in which the sides are less than 10, 5, 3, 2, 1 or even 0.5 mm long. Thereby, the amount of waste of wafer material can be substantially reduced, and at the same time a high fill factor can be obtained.

However, the use of a large number of relatively small solar cell involves the drawback that for a given effective surface area of the final solar cell assembly, there is an increased number of interconnections between solar cells, in parallel and/or in series, which may render the process of manufacturing the solar cell assembly more complex and/or expensive, and which may also render the entire circuit less reliable, due to the risk for errors due to defective interconnections between individual solar cells.
US-4,045,245-A discloses a solar cell assembly comprising a conductive layer including a first conductive portion and a second conductive portion electrically isolated from the first conductive portion, and a plurality of solar cells each including a rear surface having a first contact of a first polarity and a front surface having a second contact of a second polarity. The conductive portions are placed between electrically insulative layers. The first and second contacts of the solar cells are electrically connected to the respective conductive portions by conductive members passing through one of the electrically insulative layers.

### SUMMARY OF THE DISCLOSURE

A first aspect of the disclosure relates to a solar cell assembly comprising a plurality of solar cells and a support, the support comprising a conductive layer, such as a metal layer, comprising a first conductive portion. Each solar cell of said plurality of solar cells comprises a top or front surface and a bottom or rear surface and a first contact in correspondence with said rear surface. Each solar cell is placed on the first conductive portion with the first contact electrically connected to the first conductive portion so that the plurality of solar cells are connected in parallel through the first conductive portion. In the present disclosure, the term solar cell refers to a discrete solar cell.

Thereby, manufacturing a solar cell assembly comprising a large amount of solar cells becomes easy: the solar cells can simply be placed on the first conductive portion, which can make up a substantial part of the surface of the support, such as more than 50%, 70%, 80%, 90%, 95% or more of the total surface of the support, so that the contact or contacts at the rear surface of each solar cell can be easily connected to the first conductive portion of the support, which thus serves to interconnect the solar cells in parallel. The connection between the first contact of each solar cell and the first conductive portion of the metal layer of the support is direct and/or through a conductive bonding material. Thus, this approach is practical for creating solar cell assemblies of a large amount of relatively small solar cells, such as solar cells obtained by dividing a solar cell wafer having a substantially circular shape into a large number of individual solar cells having a substantially rectangular shape, for enhanced fill factor and wafer utilization. The first conductive portion is continuous and thus acts as a bus interconnecting the first contacts of the solar cells. In addition, the conductive layer, including the first conductive portion, can act as a thermal sink for the solar cells.

In some embodiments of the disclosure, the conductive layer comprises a second conductive portion separated from the first conductive portion, that is, the two conductive portions are not in direct contact with each other. Each of the plurality of solar cells comprises a second contact, and each of the plurality of solar cells is connected to the second conductive portion via the second contact by an interconnect connecting the second contact to the second conductive portion. Thus, a plurality of solar cells can be arranged on the substrate, connected in parallel with each other, with their first contacts -such as contacts coupled to a p-polarity side of the respective solar cell- connected to the first conductive portion and with their second contacts -such as contacts coupled to an n-polarity side of the respective solar cell connected to the second conductive portion of the respective solar cell. The first and second conductive portions can serve as bus-bars allowing the connection of the solar cell assembly to other devices, such as to other solar cell assemblies so as to make up a larger solar cell assembly.

In some embodiments of the disclosure, the first conductive portion and the second conductive portion are interconnected by means of at least one diode. This diode can act as a bypass diodes for the solar cells. Bypass diodes are frequently used in solar cell assemblies comprising a plurality of series connected solar cells or groups of solar cells. One reason for the use of bypass diodes is that if one of the solar cells or groups of solar cells is shaded or damaged, current produced by other solar cells, such as by unshaded or undamaged solar cells or groups of solar cells, can flow through the by-pass diode and thus avoid the high resistance of the shaded or damaged solar cell or group of solar cells. The diodes can be mounted on the top side of the metal layer and comprise an anode terminal and a cathode terminal. The diode can be electrically coupled in parallel with the semiconductor solar cells and configured to be reverse-biased when the semiconductor solar cells generate an output voltage at or above a threshold voltage, and configured to be forward-biased when the semiconductor solar cells generate an output voltage below the threshold voltage.

In some embodiments of the disclosure, said at least one diode comprises a top side terminal and a rear side terminal, the diode being placed on the second conductive portion with said rear side terminal of the diode electrically coupled to the second conductive portion, the top side terminal of the diode being electrically coupled to the first conductive portion. In an alternative embodiment of the disclosure, the diode can be placed on the first conductive portion with the rear side terminal of the diode electrically coupled to the first conductive portion, the top side terminal of the diode being electrically coupled to the second conductive portion. Both alternatives are possible, but it may sometimes be preferred to use the first conductive portion to support the solar cells, and the second conductive portion to support the diode or diodes.

In some embodiments of the disclosure, the first conductive portion and the second conductive portion are electrically isolated from each other by at least one cut or groove traversing the conductive layer. The groove can be produced in any suitable way, such as by etching or laser scribing. The support can be provided with a continuous metal layer on a top surface of the support, and then be subjected to a suitable treatment to establish the groove to separate the first conductive portion from the second conductive portion. The groove can cut through the conductive layer, such as a copper layer, but not through the underlying structure of the support, whereby the first conductive portion and the second conductive portion are physically coupled to each other, but electrically isolated from each other. Thus, the first and the second portion serve as two busbars by means of which the solar cell assembly can be connected to other devices, such as to other solar cell assemblies.

In some embodiments of the disclosure, the groove follows a path comprising a plurality of segments arranged one after the other, each segment extending at an angle, such as at an angle of 90 degrees, with respect to a preceding segment and/or with respect to a following segment.

In some embodiments of the disclosure, the groove comprises a plurality of segments, at least one of said segments extending in parallel with another of said segments.

In some embodiments of the disclosure, at least one portion of the groove follows a substantially meandering path.

In some embodiments of the disclosure, the second conductive portion comprises a plurality of substantially elongated subportions that extend between subportions of the first conductive portion. In some embodiments of the disclosure, these subportions can have a substantially strip-like shape.

In some embodiments of the disclosure, the surface area of the first conductive portion is larger than the surface are of the second conductive portion, such as more than twice, for example more than five, ten or twenty times the surface area of the second conductive portion.

In some embodiments of the disclosure, the solar cell assembly comprises a plurality of rows of solar cells placed on the first conductive portion, each row of solar cells being connected two a subportion of the second conductive portion extending between two rows of solar cells.

By means of features such as one or more of the ones listed above, the first and the second conductive portions can be designed for optimized use of the surface of the support, for example, for providing a maximum surface for the placement of solar cells, whereby the second conductive portion provides for conductive tracks that can, for example, extend between rows of solar cell, so that each track serves for collecting the current produced by, for example, one or two rows of solar cells. Thus, the first and the second conductive portions can have sophisticated shapes, including, when viewed from above, extensions of one of said portions entering recesses in the other one, and vice-versa.

In some embodiments of the disclosure, each solar cell has a surface area of less than 1 cm². The approach of the disclosure can be especially advantageous in the case of relatively small solar cells, such as solar cells having a surface area of less than 1 cm², less than 0.1 cm² or even less than 0.05 cm² or 0.01 cm². For example, substantially rectangular -such as square- solar cells can be obtained in which the sides are less than 10, 5, 3, 2, 1 or even 0.5 mm long. This makes it possible to obtain rectangular solar cells out of a substantially circular wafer with reduced waste of wafer material, while the approach of the disclosure makes it possible to easily place and interconnect a large number of said solar cells in parallel, so that they, in combination, perform as a larger solar cell.

In some embodiments of the disclosure, each solar cell is bonded to the first conductive portion by a conductive bonding material. Using a conductive bonding material makes it possible to establish the connection between the first contact of each solar cell and the support by simply bonding the solar cell to the support using the conductive bonding material. The conductive bonding material can be selected to enhance heat transfer between solar cell and support.

In some embodiments of the disclosure, the conductive bonding material is an indium alloy. Indium alloys have been found to be useful and advantageous, in that indium can make the bonding material ductile, thereby allowing the use of the bonding material spread over a substantial part of the surface of the support without making the support substantially more rigid and reducing the risk of formation of cracks when the assembly is subjected to bending forces. Preferably, support, solar cells and bonding material are matched to each other to feature, for example, similar thermal expansion characteristics. On the other hand, the use of a metal alloy, such as an indium alloy, is advantageous over other bonding material such as polymeric adhesives in that it allows for efficient heat dissipation into the underlying conductive layer, such as for example a copper layer. In some embodiments of the disclosure, the bonding material is indium lead.

In some embodiments of the disclosure, the conductive layer comprises copper.

In some embodiments of the disclosure, the support comprises a Kapton® film, the conductive layer being placed on the Kapton® film. The option of using a Kapton® film for the support is practical for, for example, space applications.

In some embodiments of the disclosure, the first contact of each solar cell comprises a conductive, such as a metal, layer extending over a substantial portion of the rear surface of the respective solar cell, preferably over more than 50% of the rear surface of the respective solar cell, more preferably over more than 90% of the rear surface of the respective solar cell. In some embodiments of the disclosure, the first contact comprises a conductive, such as a metal, layer covering the entire rear surface of the solar cell. This helps to establish a good and reliable contact with the first conductive portion of the conductive layer of the support.

In some embodiments of the disclosure, each solar cell comprises at least one III-V compound semiconductor layer. As indicated above, high wafer utilization can be especially advantageous when the solar cells are high efficiency solar cells such as III-V compound semiconductor solar cells, often implying the use of relatively expensive wafer material.

In some embodiments of the disclosure, the solar cell assembly has a substantially rectangular shape and a surface area in the range of 25-400 cm².

Another aspect of the disclosure relates to a solar cell assembly comprising a plurality of solar cell subassemblies, each of these solar cell subassemblies comprising a solar cell assembly according to the first aspect of the disclosure. As indicated above, the solar cell assemblies can advantageously serve as sub-assemblies which can be interconnected to form a major solar cell assembly, comprising, for example, an array of such solar cell subassemblies comprising a plurality of strings of such solar cell subassemblies, each string comprising a plurality of solar cell subassemblies connected in series. Thus, a modular approach can be used for the manufacture of relatively large solar cell assemblies out of small solar cells, which are assembled to form subassemblies as described above, whereafter the subassemblies are interconnected to form a larger assembly.

A further aspect of the disclosure relates to a method of manufacturing a solar cell assembly, comprising the steps of: providing a support comprising a support layer and a conductive layer; providing a plurality of solar cells, each solar cell having a front surface and a rear surface, each solar cell having a first contact at the rear surface and a second contact at the front surface; separating the conductive layer into a first conductive portion and a second conductive portion, electrically isolated from each other; placing the plurality of solar cells on the first portion so that the solar cells are connected to the first portion by the first contacts, directly or directly through a conductive bonding material; and connecting the second contacts of the solar cells to the second conductive portion.

In some embodiments of the disclosure, the method further comprises the steps of placing at least one diode on the second conductive portion with a first terminal of the diode connected to the second conductive portion, and connecting a second terminal of the diode to the first conductive portion. This diode can serve as a bypass diode for the solar cells.

In some embodiments of the disclosure, the step of separating the conductive layer into the first conductive portion and the second conductive portion comprises providing at least one groove through the conductive layer. In some embodiments of the disclosure, the step of providing at least one groove comprises providing the groove by laser scribing or etching. In other embodiments of the disclosure, other methods can be used for providing the groove or grooves.

In some embodiments of the disclosure, the step of providing a groove comprises providing a groove following a path comprising a plurality of segments arranged one after the other, each segment extending at an angle, such as at an angle of approximately 90 degrees, with respect to a preceding segment and/or with respect to a following segment.

In some embodiments of the disclosure, the step of providing a plurality of solar cells comprises obtaining a plurality of substantially rectangular solar cells, such as square solar cells, out of a substantially circular wafer. In some embodiments of the disclosure, each of said solar cells has a surface area of less than 1 cm². The approach of the disclosure can be especially advantageous in the case of relatively small solar cells, such as solar cells having a surface area of less than 1 cm², less than 0.1 cm² or even less than 0.05 cm² or 0.01 cm². For example, substantially rectangular -such as square- solar cells can be obtained in which the sides are less than 10, 5, 3, 2, 1 or even 0.5 mm long. This makes it possible to obtain rectangular solar cells out of a substantially circular wafer with a small waste of wafer material, whereas the approach of the disclosure makes it possible to easily place an interconnect a large number of said solar cells in parallel, so that they, in combination, perform as a larger solar cell.

### BRIEF DESCRIPTION OF THE DRAWINGS

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:
Figure 1 schematically illustrates a prior art arrangement for producing a closely packed solar cell array out of square solar cells obtained from a circular solar cell wafer.
Figure 2 schematically illustrates how circular solar cells packed to obtain a maximum fill factor imply a hexagonal unit cell for the arrangement of solar cells in an array of solar cells, or a solar cell assembly.
Figure 3 is a perspective view of a support that can be used when carrying out some of the embodiments of the disclosure.
Figure 4 is a perspective view of the support after a step of cutting a meandering groove traversing a top metal layer of the support.
Figures 5A-5D schematically illustrate a series of steps of a process for manufacturing
   a solar cell assembly using the support of Figure 4.
Figure 5E is a circuit diagram of the solar cell assembly of Figure 5D.
Figures 6A-6E schematically illustrate a series of steps of a process for manufacturing a solar cell assembly in accordance with another embodiment of the disclosure.
Figure 7 is a schematic cross-sectional view of a portion of a solar cell assembly as per figure 5D.

### DETAILED DESCRIPTION

The present disclosure provides a process for the design and fabrication of a solar cell array panel utilizing interconnected modular subassemblies. Although principally concerned with the structure and organization of the modular subassemblies, the solar cells are essential components of such subassemblies, and thus a discussion of III-V compound semiconductor solar cells is in order here.

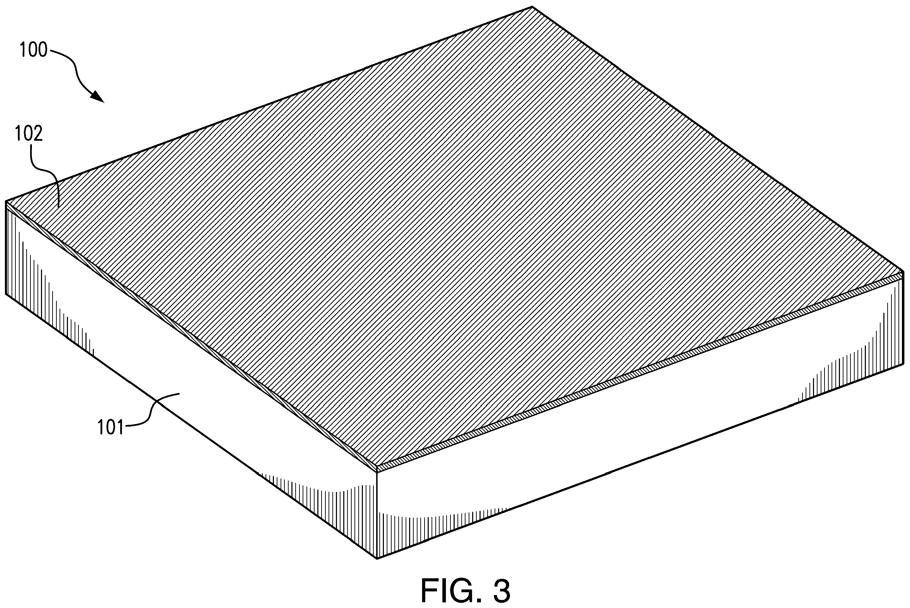

Figure 3 illustrates an example of a support that can be used in an embodiment of the disclosure. The support comprises an insulating support layer 101 and a conductive metal layer 102 arranged on a top surface of the support layer 101. In some embodiments of the disclosure, the metal layer 102 is a copper layer, having a thickness in the range of from 1µm and up to 50 µm. In some embodiments of the disclosure, the support layer 101 is a Kapton® layer, that is, a polyimide film layer. Preferably the metal layer is attached to the support layer in an adhesive-less manner, to limit outgassing when used in a space environment. In some embodiments of the disclosure the support layer can have a thickness in the range of 1mil (25.4 µm) to 4mil (101.6 µm). In some embodiments of the disclosure, a support can be provided comprising Kapton®, or another suitable support material, on both sides of the metal film 102, with cut-outs for the attachment of solar cells and interconnects to the metal film.

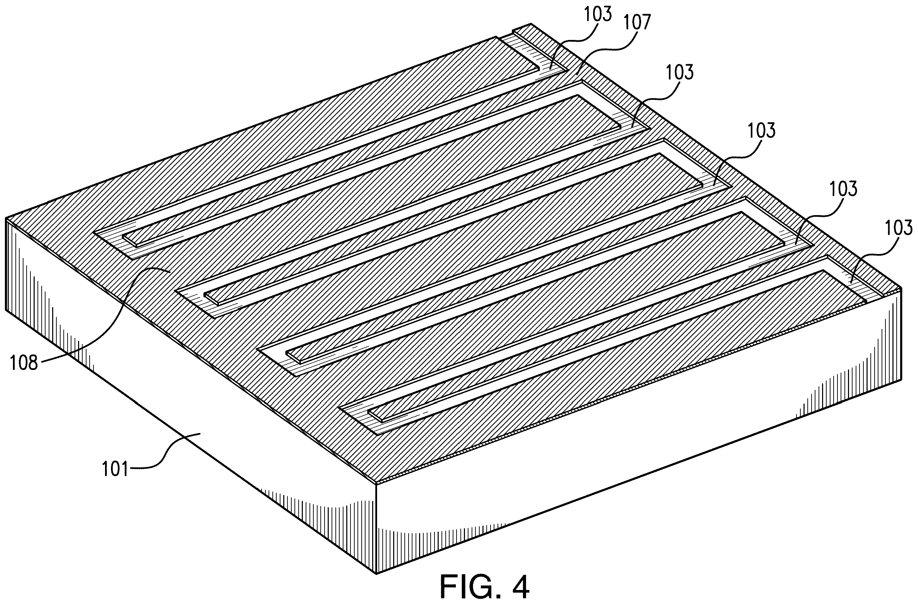

Figure 4 illustrates the support 100 of Figure 3 after a step in which part of the metal layer 102 has been removed, by for example etching or laser scribing, whereby a channel or groove 103 is formed traversing the metal layer, separating it into a first conductive portion 108 and a second conductive portion 107. It can be observed how the two portions are nested with each other: the groove 103 follows a meandering path, whereby the first conductive portion 108 features a set of substantially parallel strips connected to each other at one end thereof. The second conductive portion 107 also comprises a set of strips, extending partly in parallel with the strips of the first conductive portion, between adjacent strips of said first conductive portion. It can be seen how the first conductive portion 108 and the second conductive portion 107 are electrically isolated from each other due to the presence of the groove, which traverses the metal layer from a top surface thereof down to the support layer 101.

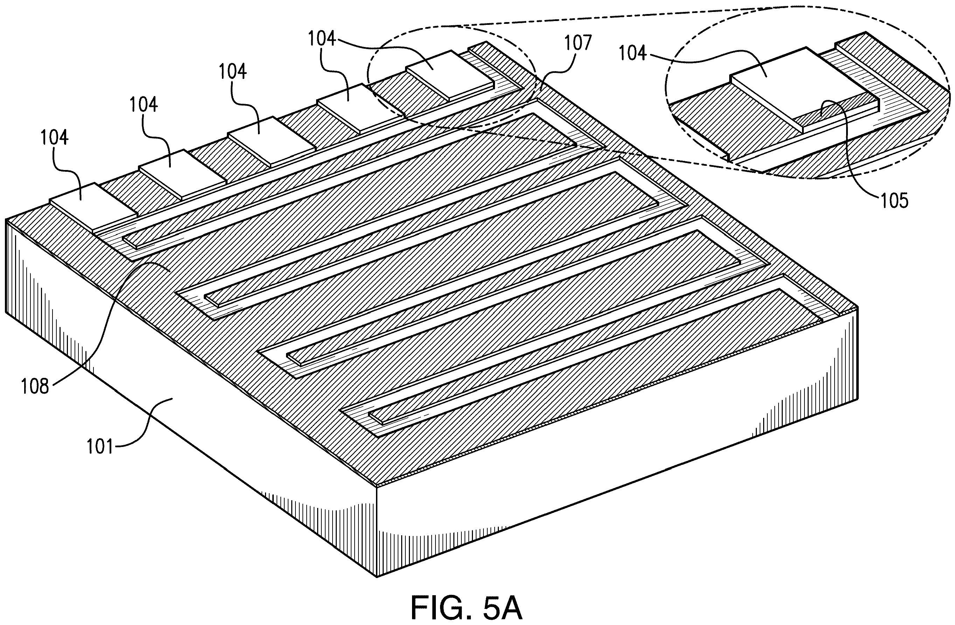

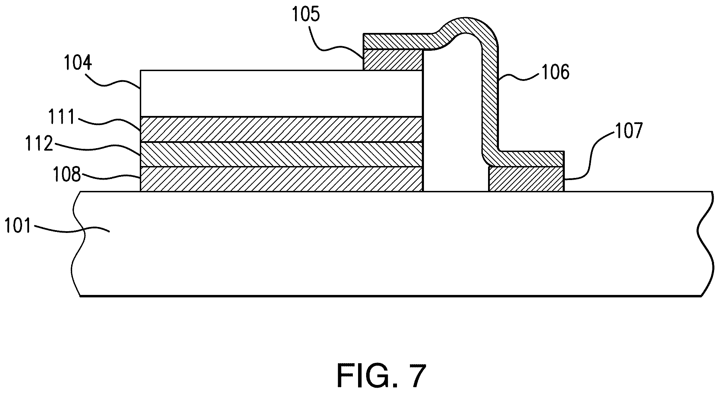

Figure 5A schematically illustrates how a plurality of solar cells 104 have been attached to the first conductive portion 108. Only five of these solar cells 104 are shown in Figure 5A for simplicity, and in Figure 5A the solar cells 104 have been illustrated substantially spaced from each other. However, in practice solar cells 104 are preferably placed close to each other and all throughout the first conductive portion, so as to optimize space utilization: it is preferred that a substantial percentage, such as more than 50%, 60%, 70%, 80% or 90%, such as more than 95%, of the surface of the support 101 is covered by solar cells, so as to provide for an optimized W/m² or W/kg ratio. Each solar cell comprises a first contact 111 on a rear or bottom surface of the solar cell, as shown in Figure 7, and a second contact 105 on a front or top surface of the solar cell. In some embodiments of the disclosure, the first contact 111 comprises a metal layer covering the entire rear surface of the solar cell or a substantial portion of the rear surface of the solar cell, and the second contact 105 is placed adjacent to an edge of the front surface of the solar cell 104. The second contact 105 has preferably a small surface area to allow the major part of the front surface of the solar cell to be an effective surface for the conversion of sunlight into electric power. In Figure 5A, the second contact 105 is only shown for one of the solar cells, for simplicity.

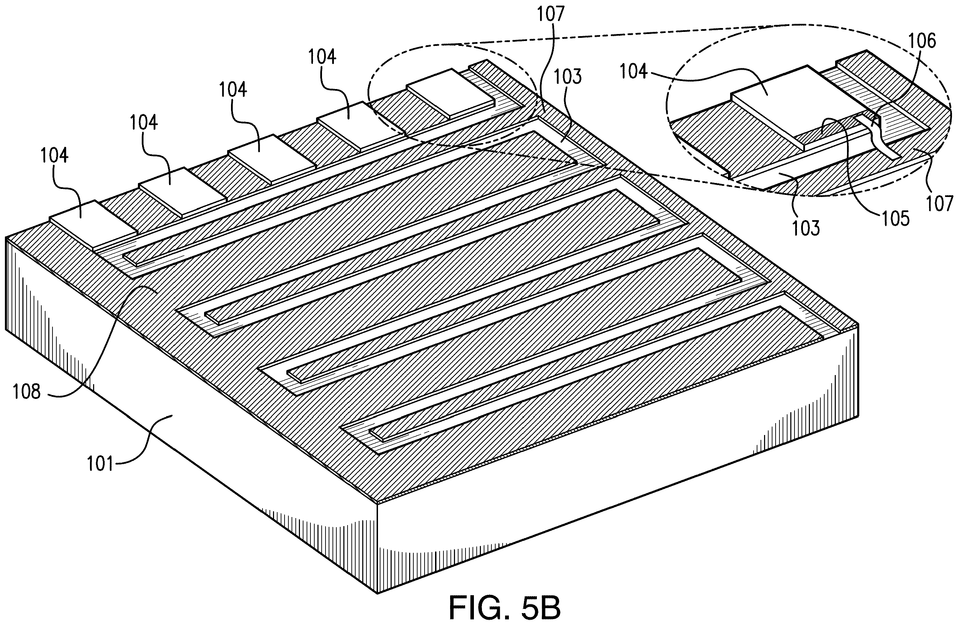

The solar cell 104 is preferably attached to the first conductive portion 108 by a conductive bonding material 112 as shown in Figure 7, such as a layer of a metal alloy, such as an indium alloy, such as an indium lead alloy. As is easily understood from Figure 5B and Figure 7, the metal layer including the first conductive portion 108 serves as a heat sink for the solar cells, and an indium alloy such as indium lead has appropriate heat conduction characteristics. At the same time, indium is advantageous as it provides for ductility, thereby reducing the risk for cracks in the bonds between the solar cells and the first conductive portion 108 when the assembly is subjected to bending forces.

Figure 5B shows the result of a further step of the process, in which the second contact 105 of each solar cell has been connected to the second conductive portion 107 by a connecting member or interconnect 106 (only one of these interconnects 106 is shown in Figure 5B, for simplicity).

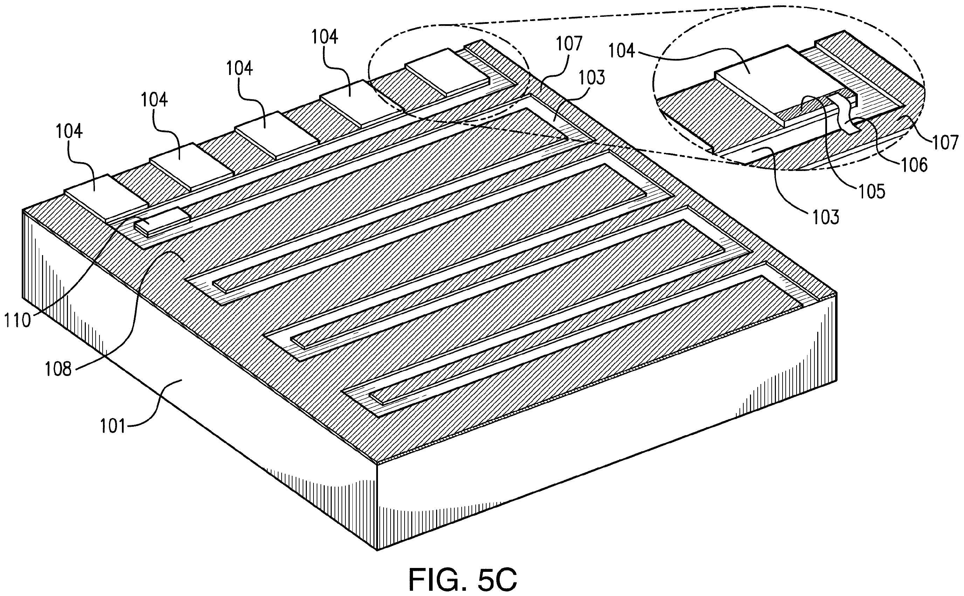

Figure 5C illustrates the solar cell assembly after the next process step, in which a bypass diode 110 has been attached to the second conductive portion at a free end of one of the strips. The diode has a rear terminal which is connected to the second conductive portion 107, for example, by means of an indium alloy.

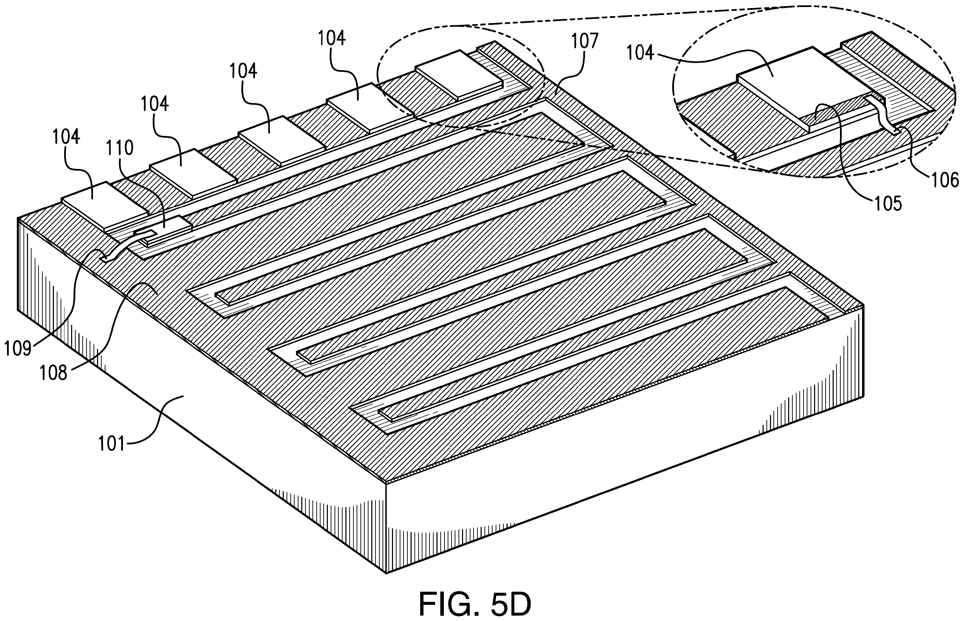

Figure 5D illustrates the solar cell assembly after the next process step in which a bypass diode interconnect 109 is attached to electrically connect a top terminal of the bypass diode 110 with the first conductive portion 108.

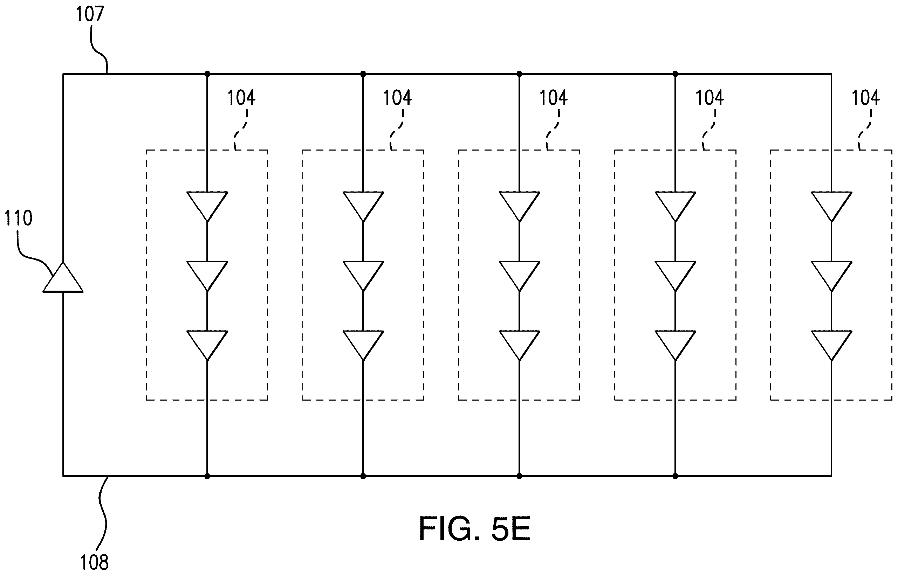

Figure 5E is a circuit diagram of the assembly shown in figure 5D, in which five solar cells 104 are connected in parallel between two bus bars 107 and 108, corresponding to the second and to the first conductive portions, respectively, and with a bypass diode 110 common to the five solar cells. Each solar cell is a multijunction solar cell.

It is clear from the embodiment schematically shown in figures 5A-5D how many small solar cells, such as solar cells having a surface area of less than 1 cm², less than 0.1 cm² or less than 0.01 cm², can easily be placed on the first conductive portion 108 such as on different subareas, tracks or strips of the first conductive portion, and bonded to it by bonding their back sides to the first conductive portion using a conductive bond that connects that first or rear contact of the solar cell to the first conductive portion 108, and how interconnects can be added to connect the second or upper contacts of the solar cells to the second conductive portion 107. One or more bypass diodes can easily be added, as shown.

Thus, an assembly of a plurality of solar cells connected in parallel is obtained, and this kind of assembly can be used as a subassembly, together with more subassemblies of the same kind, to form a larger assembly including strings of series connected subassemblies.

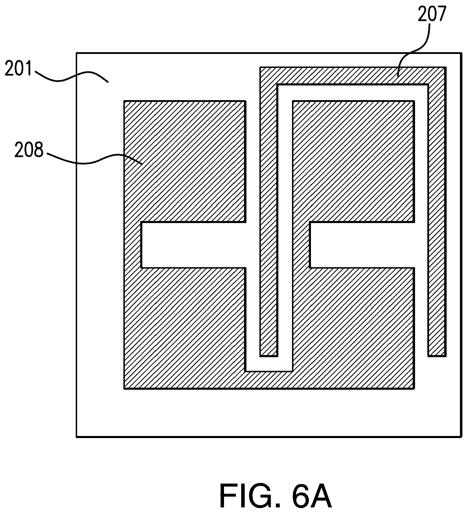

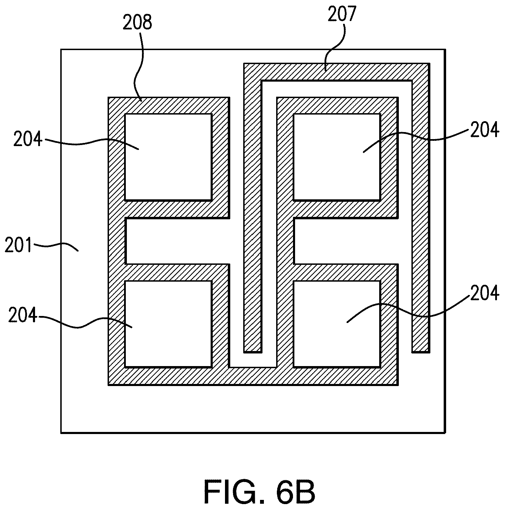

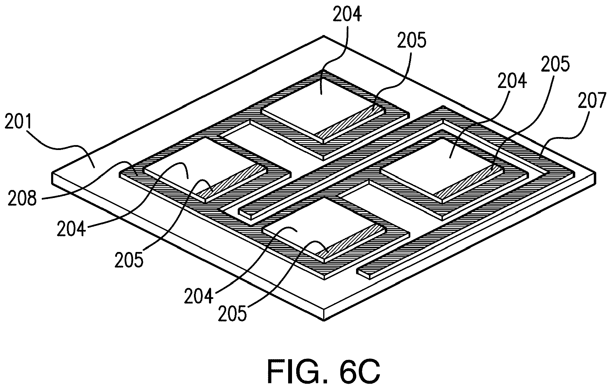

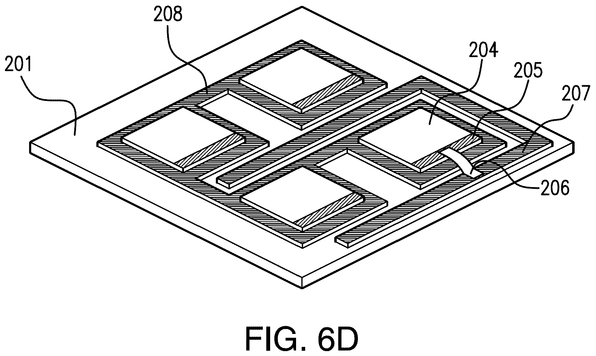

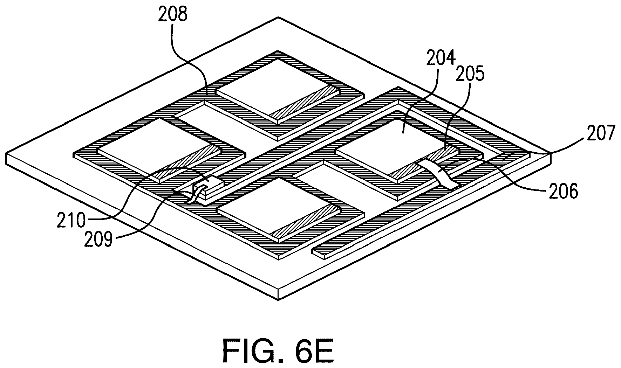

Figures 6A-6E schematically illustrate the different stages of a process in accordance with another embodiment of the disclosure. In Figure 6A the substrate is shown after elimination of part of the metal layer, so that the substrate layer 201, such as a Kapton layer, is covered by a first conductive portion 208 and a second conductive portion 207. The second conductive portion 207 comprises three segments following a meandering path or a portion of a meandering path, and the first conductive portion 208 comprises four major, substantially square, portions interconnected by three shorts strips. In Figure 6B, one substantially rectangular solar cell has been placed on each of the square portions of the first conductive portion 208. Figure 6C is a perspective view in which the second contacts 205 of the solar cells 204 can be observed. Figure 6D schematically illustrates how an interconnect 206 has been added to connect the second contact 205 of one of the solar cells 204 to the second conductive portion or busbar 207 (only one such interconnect is shown in the drawing, for simplicity). In figure 6E, a bypass diode 210 and its interconnect have been added to interconnect the first conductive portion and the second conductive portion.

Just as in the case of Figures 5A-5D, also figures 6A-6E are only intended to schematically show an embodiment of the disclosure. In practice, the spatial distribution will mostly differ: solar cells are to be packed relatively close to each other and arranged to occupy most of the surface of the assembly, so as to contribute to efficient space utilization from a W/m² perspective.

Figure 7 schematically illustrates layers of a cross-section of a portion of the assembly of the embodiment of Figure 5D. A Kapton® support layer 101 supports copper strips 108 and 107, and a solar cell 104 having a bottom metal layer 111 forming a first contact is bonded to the copper strip 108 by an indium alloy layer 112. A second contact 105 at the upper surface of the solar cell 104 is connected to the copper strip 107 by the interconnect 106.

It is to be noted that the terms "front", "back", "top" , "bottom", "over", "on", "under", and the like in the description and in the claims, if any, are used for descriptive purposes and not necessarily for describing permanent relative positions. It is understood that the terms so used are interchangeable under appropriate circumstances such that the embodiments of the disclosure described herein are, for example, capable of operation in other orientations than those illustrated or otherwise described herein.

Furthermore, those skilled in the art will recognize that boundaries between the above described operations are merely illustrative. The multiple units/operations may be combined into a single unit/operation, a single unit/operation may be distributed in additional units/operations, and units/operations may be operated at least partially overlapping in time. Moreover, alternative embodiments may include multiple instances of a particular unit/operation, and the order of operations may be altered in various other embodiments.

In the claims, the word 'comprising' or 'having' does not exclude the presence of other elements or steps than those listed in a claim. The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to disclosures containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage.

The present disclosure can be embodied in various ways. The above described orders of the steps for the methods are only intended to be illustrative, and the steps of the methods of the present disclosure are not limited to the above specifically described orders unless otherwise specifically stated. Note that the embodiments of the present disclosure can be freely combined with each other without departing from the spirit and scope of the disclosure.

Although some specific embodiments of the present disclosure have been demonstrated in detail with examples, it should be understood by a person skilled in the art that the above examples are only intended to be illustrative but not to limit the scope of the present disclosure. It should be understood that the above embodiments can be modified without departing from the scope of the present disclosure which is defined by the attached claims.

## Claims

1. A solar cell assembly comprising:
a support comprising a conductive layer (102) including a first conductive portion (108, 208) and a second conductive portion (107, 207) electrically isolated from the first conductive portion (108, 208); and
a plurality of solar cells (104, 204), each solar cell including a front surface and a rear surface, each solar cell having a first contact (111) of a first polarity at the rear surface and a second contact (105, 205) of a second polarity at the front surface, the first contact (111) being electrically connected to the first conductive portion (108, 208) of the support directly or directly through a conductive bonding material (112) and the second contact (105, 205) being electrically connected to the second conductive portion (107, 207) of the support so that the solar cells (104, 204) are connected in parallel through the first and second conductive portions.

2. The solar cell assembly of claim 1, wherein the conductive layer comprises a planar structure with the first conductive portion (108, 208) being separated from the second conductive portion (107, 207), each of the plurality of solar cells (104, 204) being connected to the second conductive portion (107, 207) via the second contact of the solar cell by an interconnect (106, 206) connecting the second contact (105, 205) of the solar cell to the second conductive portion (107, 207).

3. The solar cell assembly of any of the preceding claims, wherein the first conductive portion (108, 208) and the second conductive portion (107, 207) are interconnected by means of at least one bypass diode (110, 210).

4. The solar cell assembly of claim 3, wherein the at least one bypass diode comprises a top side terminal and a rear side terminal, the bypass diode (110, 210) being disposed on the second conductive portion (107, 207) with said rear side terminal of the bypass diode electrically coupled to the second conductive portion (107, 207), the top side terminal of the bypass diode (110, 210) being electrically coupled to the first conductive portion (108, 208) by a discrete interconnect element (109, 209).

5. The solar cell assembly of any of the preceding claims, wherein the support comprises a polyimide film having a thickness between 25.4 µm and 101.6 µm.

6. The solar cell assembly of claim 2, wherein the support includes a top surface and a bottom surface, the first conductive portion (108, 208) and the second conductive portion (107, 207) are disposed on the same surface of the support and are electrically isolated from each other by at least one groove (103) separating the first conductive portion (108, 208) from the second conductive portion (107, 207).

7. The solar cell assembly of claim 6, wherein the groove (103) follows a path comprising a plurality of discrete segments serially arranged one after the other, each segment extending at an angle with respect to a preceding segment and/or with respect to a following segment.

8. The solar cell assembly of claim 6, wherein the groove (103) comprises a plurality of discrete segments, at least one of said discrete segments extending in parallel with another one of said segments.

9. The solar cell assembly of claim 6, wherein at least one portion of the groove (103) follows a substantially meandering path.

10. The solar cell assembly of any of the preceding claims, wherein the surface area of the assembly is in the range of 25 to 400 square centimeters.

11. The solar cell assembly of claim 2, wherein the solar cell assembly comprises a plurality of rows of solar cells (104, 204) placed on the first conductive portion (108, 208), each row of solar cells being connected to a subportion of the second conductive portion (107, 207) extending between two rows of solar cells.

12. The solar cell assembly of any of the preceding claims, wherein each solar cell (104, 204) is a III-V compound semiconductor solar cell and has a surface area of less than 1 cm².

13. The solar cell assembly of any of the preceding claims, wherein each solar cell is bonded to the first conductive portion by a conductive bonding material (112).

14. The solar cell assembly of claim 13, wherein the conductive bonding material is an indium alloy.

15. A method of manufacturing a solar cell assembly:
providing a support including (i) a support layer (101, 201) and (ii) a conductive layer (102) disposed on the support layer;
providing a plurality of III-V compound semiconductor solar cells (104, 204), each solar cell having a front surface and a rear surface, each solar cell having a first contact (111) of a first polarity at the rear surface and a second contact (105, 205) of a second polarity at the front surface;
etching or laser scribing the conductive layer into a first conductive portion (108, 208) and a second conductive portion (107, 207) so that the first and second conductive portions are electrically isolated from each other;
bonding the plurality of solar cells (104, 204) to the first conductive portion (108, 208) so that the first contact of each of the solar cells are electrically connected to the first conductive portion directly or directly through a conductive bonding material (112); and
connecting the second contacts (105, 205) of the solar cells to the second conductive portion (107, 207) by discrete electrical interconnect elements (106, ,206).

## Patentansprüche

1. Solarzellenanordnung, aufweisend:
einen eine Leitungsschicht (102) aufweisenden Träger, wobei die Leitungsschicht (102) einen ersten leitenden Bereich (108, 208) und einen vom ersten Bereich (108, 208) elektrisch isolierten, zweiten leitenden Bereich (107, 207) aufweist; und
eine Mehrzahl Solarzellen (104, 204), deren Solarzellen jeweils eine Vorderseite und eine Rückseite, und einen ersten Kontakt (111) einer ersten Polarität auf der Rückseite, sowie einen zweiten Kontakt (105, 205) einer zweiten Polarität auf der Vorderseite aufweisen,
wobei der erste Kontakt (111) elektrisch mit dem ersten leitenden Bereich (108, 208) des Trägers unmittelbar oder unmittelbar durch ein leitendes Kontaktmaterial (112) verbunden ist, und der zweite Kontakt (105, 205) derart mit dem zweiten leitenden Bereich (107, 207) des Trägers elektrisch verbunden ist, dass die Solarzellen (104, 204) über den ersten und zweiten leitenden Bereich parallel miteinander verbunden sind.

2. Solarzellenanordnung nach Anspruch 1, wobei die Leitungsschicht eine ebene Struktur mit einem vom zweiten leitenden Bereich (107, 207) getrennten, ersten leitenden Bereich (108, 208) aufweist, und eine Solarzelle der Mehrzahl von Solarzellen jeweils über den zweiten Kontakt der Solarzelle mittels einer Kontaktbrücke mit dem zweiten leitenden Bereich (107, 207) verbunden ist, wobei die Kontaktbrücke den zweiten Kontakt (105, 205) der Solarzelle mit dem zweiten leitenden Bereich (107, 207) verbindet.

3. Solarzellenanordnung nach einem der vorhergehenden Ansprüche, wobei der erste leitende Bereich (108, 208) und der zweite leitende Bereich (107, 207) mittels wenigstens einer Überbrückungsdiode (110, 210) miteinander verbunden sind.

4. Solarzellenanordnung nach Anspruch 3, wobei die wenigstens eine Überbrückungsdiode einen Vorderseitenanschluss und einen Rückseitenanschluss aufweist, wobei die Überbrückungsdiode (110, 201) auf dem zweiten leitenden Bereich (107, 207) angeordnet und der Rückseitenanschluss der Überbrückungsdiode mit dem zweiten leitenden Bereich (107, 207) elektrisch gekoppelt ist und wobei der Vorderseitenanschluss der Überbrückungsdiode (110, 210) mit dem ersten leitenden Bereich (108, 208) mittels eines separaten Brückenelementes (109, 209) gekoppelt ist.

5. Solarzellenanordnung nach einem der vorhergehenden Ansprüche, wobei der Träger einen Polyimid Überzug mit einer Dicke zwischen 25.4 µm und 101.6 µm aufweist.

6. Solarzellenanordnung nach Anspruch 2, wobei der Träger eine obere Fläche und eine untere Fläche aufweist, der erste leitende Bereich (108, 208) und der zweite leitende Bereich (107, 207) auf derselben Fläche des Trägers angeordnet und elektrisch voneinander mittels wenigstens einer Spalte (103) isoliert sind, wobei die wenigstens eine Spalte (103) den ersten leitenden Bereich (108, 208) vom zweiten leitenden Bereich (107, 207) trennt.

7. Solarzellenanordnung nach Anspruch 6, wobei die Spalte (103) einem Pfad folgt, der eine Mehrzahl von seriell nacheinander angeordneter, einzelner Abschnitte aufweist und jeder Abschnitt in Bezug zum vorherigen Abschnitt und/oder zum folgenden Abschnitt in einem Winkel abgeht.

8. Solarzellenanordnung nach Anspruch 6, wobei die Spalte (103) eine Mehrzahl einzelner Abschnitte aufweist und wenigstens ein Abschnitt parallel zu einem der anderen Abschnitte verläuft.

9. Solarzellenanordnung nach Anspruch 6, wobei wenigstens ein Teil der Spalte (103) einem im Wesentlichen mäandrierenden Pfad folgt.

10. Solarzellenanordnung nach einem der vorhergehenden Ansprüche, wobei ein Inhalt einer der Flächen der Anordnung in einem Bereich von 25 bis 400 Quadratzentimeter liegt.

11. Solarzellenanordnung nach Anspruch 2, wobei die Solarzellenanordnung eine Mehrzahl von auf dem ersten leitenden Bereich (108, 208) angeordneten Solarzellenreihen (104, 204) aufweist, wobei jeweils eine der Solarzellenreihen mit einem, sich zwischen zwei Solarzellenreihen erstreckenden Unterbereich des zweiten leitenden Bereiches (107, 207) verbunden ist.

12. Solarzellenanordnung nach einem der vorhergehenden Ansprüche, wobei jede Solarzelle (104, 204) eine III-V-Verbindungshalbleiter-Solarzelle mit einem Flächeninhalt von weniger als einem Quadratzentimeter ist.

13. Solarzellenanordnung nach einem der vorhergehenden Ansprüche, wobei jede Solarzelle zum ersten leitenden Bereich mittels eines leitenden Kontaktmaterials (112) gebondet ist.

14. Die Solarzellenanordnung nach Anspruch 13, wobei das leitende Kontaktmaterial (112) eine Indium Legierung ist.

15. Verfahren zur Herstellung einer Solarzellenanordnung:
- Bereitstellen eines Trägers, aufweisend (i) eine Trägerschicht (101, 201) und (ii) eine auf der Trägerschicht angeordnete Leitungsschicht (102);
- Bereitstellen einer Mehrzahl von III-V-Verbindungshalbleiter-Solarzellen (104, 204), wobei die Solarzellen jeweils Vorderseite und Rückseite, sowie jeweils einen ersten Kontakt (111) einer ersten Polarität an der Rückseite und einen zweiten Kontakt (105, 205) einer zweiten Polarität an der Vorderseite aufweisen;
- Ätzen oder Laserbehandeln der Leitungsschicht, um einen ersten leitenden Bereich (108, 208) und einen zweiten leitenden Bereich (107, 207) derart zu bilden, dass der erste und der zweite leitende Bereich elektrisch voneinander isoliert sind;
- Bonden der Mehrzahl von Solarzellen (104, 204) an den ersten leitenden Bereich (108, 208) in der Art, dass der erste Kontakt jeweils einer Solarzelle elektrisch mit dem ersten leitenden Bereich unmittelbar oder unmittelbar durch ein leitendes Kontaktmaterial (112) verbunden ist; und
- Verbinden der zweiten Kontakte (105, 205) der Solarzellen zum zweiten leitenden Bereich (107, 207) mittels separater Brückenelemente (106, 206).

## Revendications

1. Assemblage de cellules solaires comprenant :
un support comprenant une couche conductrice (102) incluant une première partie conductrice (108, 208) et une deuxième partie conductrice (107, 207) isolée électriquement de la première partie conductrice (108, 208) ; et
une pluralité de cellules solaires (104, 204), chaque cellule solaire incluant une surface frontale et une surface arrière, chaque cellule solaire ayant un premier contact (111) d'une première polarité sur la surface arrière, et un deuxième contact (105, 205) d'une deuxième polarité sur la surface frontale, le premier contact (111) étant électriquement connecté à la première partie conductrice (108, 208) du support directement ou directement par l'intermédiaire d'un matériau de liaison conducteur (112), et le deuxième contact (105, 205) étant électriquement connecté à la deuxième partie conductrice (107, 207) du support, de sorte que les cellules solaires (104, 204) sont connectées en parallèle par l'intermédiaire de la première et de la deuxième partie conductrice.

2. Assemblage de cellules solaires selon la revendication 1, dans lequel la couche conductrice comprend une structure plane, la première partie conductrice (108, 208) étant séparée de la deuxième partie conductrice (107, 207), chacune de la pluralité de cellules solaires (104, 204) étant connectée à la deuxième partie conductrice (107, 207) via le deuxième contact de la cellule solaire par une interconnexion (106, 206) connectant le deuxième contact (105, 205) de la cellule solaire à la deuxième partie conductrice (107, 207).

3. Assemblage de cellules solaires selon l'une quelconque des revendications précédentes, dans lequel la première partie conductrice (108, 208) et la deuxième partie conductrice (107, 207) sont interconnectées au moyen d'au moins une diode bypass (110, 210).

4. Assemblage de cellules solaires selon la revendication 3, dans lequel la au moins une diode bypass comprend une borne supérieure et une borne arrière, la diode bypass (110, 210) étant disposée sur la deuxième partie conductrice (107, 207), la borne arrière de la diode bypass étant couplée électriquement à la deuxième partie conductrice (107, 207), la borne supérieure de la diode bypass (110, 210) étant couplée électriquement à la première partie conductrice (108, 208) par un élément d'interconnexion discret (109, 209).

5. Assemblage de cellules solaires selon l'une quelconque des revendications précédentes, dans lequel le support comprend un film en polyimide ayant une épaisseur comprise entre 25,4 µm et 101,6 µm.

6. Assemblage de cellules solaires selon la revendication 2, dans lequel le support comprend une surface supérieure et une surface inférieure, la première partie conductrice (108, 208) et la deuxième partie conductrice (107, 207) étant disposées sur la même surface du support et étant électriquement isolées l'une de l'autre par au moins une rainure (103) séparant la première partie conductrice (108, 208) de la deuxième partie conductrice (107, 207).

7. Assemblage de cellules solaires selon la revendication 6, dans lequel la rainure (103) suit un trajet comprenant une pluralité de segments discrets disposés en série les uns après les autres, chaque segment s'étendant selon un angle par rapport à un segment précédent et/ou par rapport à un segment suivant.

8. Assemblage de cellules solaires selon la revendication 6, dans lequel la rainure (103) comprend une pluralité de segments discrets, au moins un desdits segments discrets s'étendant parallèlement à un autre desdits segments.

9. Assemblage de cellules solaires selon la revendication 6, dans lequel au moins une partie de la rainure (103) suit un trajet sensiblement sinueux.

10. Assemblage de cellules solaires selon l'une quelconque des revendications précédentes, dans lequel l'aire de la surface de l'assemblage se trouve dans l'intervalle compris entre 25 et 400 centimètres carrés.

11. Assemblage de cellules solaires selon la revendication 2, dans lequel l'assemblage de cellules solaires comprend une pluralité de rangées de cellules solaires (104, 204) placées sur la première partie conductrice (108, 208), chaque rangée de cellules solaires étant connectée à une sous-partie de la deuxième partie conductrice (107, 207) s'étendant entre deux rangées de cellules solaires.

12. Assemblage de cellules solaires selon l'une quelconque des revendications précédentes, dans lequel chaque cellule solaire (104, 204) est une cellule solaire à semiconducteur en composant III-V et a une aire de surface inférieure à 1 cm².

13. Assemblage de cellules solaires selon l'une quelconque des revendications précédentes, dans lequel chaque cellule solaire est liée à la première partie conductrice par un matériau de liaison conducteur (112).

14. Assemblage de cellules solaires selon la revendication 13, dans lequel le matériau de liaison conducteur est un alliage d'indium.

15. Procédé de fabrication d'un assemblage de cellules solaires consistant à :
mettre à disposition un support incluant (i) une couche support (101, 201) et (ii) une couche conductrice (102) disposée sur la couche support ;
mettre à disposition une pluralité de cellules solaires à semi-conducteurs en composant III-V (104, 204), chaque cellule solaire ayant une surface frontale et une surface arrière, chaque cellule solaire ayant un premier contact (111) d'une première polarité sur la surface arrière, et un deuxième contact (105, 205) d'une deuxième polarité sur la surface frontale ;
mordre ou rainurer au laser la couche conductrice pour obtenir une première partie conductrice (108, 208) et une deuxième partie conductrice (107, 207) de sorte que la première et la deuxième partie conductrice sont électriquement isolées l'une de l'autre ;
lier la pluralité de cellules solaires (104, 204) à la première partie conductrice (108, 208) de sorte que le premier contact de chacune des cellules solaires est connecté électriquement à la première partie conductrice directement ou directement par l'intermédiaire d'un matériau de liaison conducteur (112) ; et
connecter les deuxièmes contacts (105, 205) des cellules solaires à la deuxième partie conductrice (107, 207) au moyen d'éléments d'interconnexion discrets (106, 206).
